# EUROPÄISCHE PATENTANMELDUNG

(11) **EP 4 763 577 A1**
(43) Veröffentlichungstag der Anmeldung: **24.06.2026**
(21) Anmeldenummer: 25215552.8
(22) Anmeldetag: 13.11.2025
(51) Int. Cl.: B60L 3/00, B60L 3/12, B60L 53/10, B60L 53/14, G01R 31/392

(54) **VERFAHREN ZUR OBD-BASIERTEN ERMITTLUNG EINES EINSATZZUSTANDS EINER BATTERIE IN EINEM ZUMINDEST TEILWEISE ELEKTRIFIZIERTEN FAHRZEUG**

(30) Priorität: 20.11.2024 DE 102024134111
(71) Anmelder: MAHLE International GmbH, 70376 Stuttgart (DE)
(72) Erfinder: Ruppricht, Peter, 73732 Esslingen (DE); Wagner, Michael, 70372 Stuttgart (DE); Gerstadt, Max, 70376 Stuttgart (DE); Storz, Niko, 73262 Reichenbach (DE); Troiani, Mariangelo, 73207 Plochingen (DE); Zernack, Alexander, 70378 Stuttgart (DE); Günter, Marcel, 71336 Waiblingen (DE); Ludwig, Lars, 73776 Altbach (DE); Wappler, Peter, 70199 Stuttgart (DE); Moser, Michael, 73479 Ellwangen (DE)

(57) **Zusammenfassung**

Die vorliegende Erfindung betrifft Verfahren zur Ermittlung eines Einsatzzustands einer Batterie (104) eines zumindest teilweise elektrifizierten Fahrzeugs (100), umfassend Erhalten von On-Board-Diagnose-Messdaten, OBD-Messdaten, des Fahrzeugs (100) über eine erste Kommunikationsschnittstelle (20), wobei die OBD-Messdaten während eines elektrisch angeregten Zustandes der Batterie (104) erzeugt sind; Auswerten der OBD-Messdaten, um einen Parameterdatensatz zu zumindest einem Betriebsparameter der Batterie (104) zu erzeugen; Ermitteln einer Zustandskennzahl der Batterie (104) aus dem Parameterdatensatz, wobei die Zustandskennzahl einen Einsatzzustand der Batterie (104) charakterisiert; wobei der elektrisch angeregte Zustand der Batterie (104) basierend auf einem Schaltvorgang eines Ladeschützes (32) einer Ladeeinrichtung (14), an die die Batterie (104) angeschlossen ist, bereitgestellt wird; und/oder wobei der elektrisch angeregte Zustand der Batterie (104) mittels einer AC-Ladeeinrichtung (14), an die die Batterie (104) angeschlossen ist, bereitgestellt wird. Die vorliegende Erfindung betrifft zusätzlich ein Steuersystem (10) zum Ausführen des Verfahrens, ein zumindest teilweise elektrifiziertes Fahrzeug (100) mit einem solchen Steuersystem (10), sowie ein entsprechendes computerlesbares Speichermedium.

## Beschreibung

Die vorliegende Erfindung betrifft das Gebiet der Elektromobilität. Insbesondere betrifft die Erfindung ein Verfahren zur Ermittlung eines Einsatzzustands einer Batterie in einem zumindest teilweise elektrifizierten Fahrzeug.

Elektrische Achsantriebe für Reinelektrofahrzeuge und Hybridelektrofahrzeuge sind aus dem Stand der Technik hinreichend bekannt. Derartige Antriebssysteme umfassen in der Regel einen Elektromotor, der mit einer Batterie, etwa Lithium-Ionen-Batterie, angetrieben wird. Die Batterie ist in der Regel als Batteriesystem aus einer Vielzahl von miteinander verbundenen Batteriezellen ausgebildet. Die Batterie stellt eine DC-Spannung bereit, die mittels eines DC/AC-Wechselrichters in eine AC-Spannung zur Erzeugung von AC-Phasenströmen umgewandelt wird. Die AC-Phasenströme werden in Statorwicklungen eingespeist, um im Stator ein magnetisches Drehfeld zu generieren, welches den ebenfalls magnetisch wirkenden Rotor in Rotation versetzt.

Für die Funktionalität des Elektrofahrzeugs ist der Einsatzzustand der Batterie maßgeblich. Somit besteht die Notwendigkeit, den Einsatzzustand der Batterie zu überwachen, um rechtzeitig auf mögliche Fehlersituationen oder Anomalien zu reagieren. Aus dem Stand der Technik ist bekannt, dies mittels Ladestationen bzw. Ladesäulen durchzuführen, indem funktionale Daten über Batterien, die an den Ladestationen aufgeladen werden/worden sind, hinsichtlich Betriebsparameter der Batterie analysiert werden. Derartige Verfahren sind nicht nur mit einem vergleichsweise komplexen Datenkommunikationsnetzwerk verbunden, sondern auch aufgrund der involvierten Datenschnittstellen fehler- und sicherheitsanfällig.

Die Aufgabe der vorliegenden Erfindung besteht daher darin, ein Verfahren zur Ermittlung eines Einsatzzustands einer Batterie in einem zumindest teilweise elektrifizierten Fahrzeug bereitzustellen, bei dem die vorstehend genannten Nachteile zumindest teilweise überwunden werden.

Die oben genannte technische Aufgabe wird durch ein Verfahren, ein Steuersystem, ein zumindest teilweise elektrifiziertes Fahrzeug sowie ein computerlesbares Speichermedium gemäß dem Hauptanspruch bzw. den nebengeordneten Ansprüchen gelöst. Vorteilhafte Ausführungsformen sind Gegenstand der abhängigen Ansprüche. Die im Zusammenhang mit den auf das Verfahren gerichteten Ansprüchen beschriebenen Vorteile finden ebenfalls Geltung für das erfindungsgemäße Steuersystem, das erfindungsgemäße Fahrzeug sowie das erfindungsgemäße Speichermedium.

Die vorliegende Erfindung betrifft in einem ersten Aspekt ein Verfahren zur Ermittlung eines Einsatzzustands einer Batterie in einem zumindest teilweise elektrifizierten Fahrzeug. Das Fahrzeug umfasst einen elektrischen Achsantrieb, welcher einen Elektromotor und einen Wechselrichter aufweist. Der Elektromotor wird mit einer DC-Spannung angetrieben, die die Batterie erzeugt. Insbesondere wird die DC-Spannung mittels des Wechselrichters in eine AC-Spannung umgewandelt, mit der mehrere AC-Phasenströme erzeugt werden. Die AC-Phasenströme werden in als Statorwicklungen ausgebildete Phasenstränge des Elektromotors eingespeist. Dies bewirkt im Stator ein rotierendes Magnetfeld bzw. Drehfeld, welches einen magnetischen Rotor in Drehbewegung versetzt und den Elektromotor auf diese Weise antreibt.

In einem ersten Verfahrensschritt werden On-Board-Diagnose-Messdaten, OBD-Messdaten, erhalten. Die OBD umfasst Messungen (OBD-Messungen) am Fahrzeug, die mittels eines OBD-Systems aufweisend mehrere Sensoren, Peripheriegeräte und Kommunikationsschnittstellen insbesondere im Fahrbetrieb des Fahrzeugs durchgeführt werden bzw. worden sind. Die Sensoren sind jeweils zur Erfassung eines bestimmten Parameters des Fahrzeugs, insbesondere der verschiedenen im Fahrzeug verbauten Komponenten, ausgebildet. Die OBD-Messdaten werden/wurden erzeugt, während sich die Batterie in einem elektrisch angeregten Zustand befindet. Die OBD-Messdaten betreffen beispielsweise einen Ladezustand (State of Charge, SOC), eine Temperatur, ein Coulomb-Counting (CC-Daten), einen oder mehrere frühere Lade- und/oder Entladeprozesse, einen Strom und/oder eine Spannung der Batterie.

Vorzugsweise werden im ersten Verfahrensschritt ausschließlich die OBD-Messdaten erhalten. Alternativ oder zusätzlich wird zur Ermittlung der Zustandskennzahl der Batterie ausschließlich der erzeugte Parameterdatensatz herangezogen. Dies führt zu einer weiteren Reduzierung der Anzahl der involvierten Datenschnittstellen und damit einhergehend zu einer weiteren Erhöhung der Sicherheit und Fehlerbeständigkeit der Batterieanalyse- und Diagnose. Außerdem wird hierdurch der Datenverarbeitungsaufwand minimiert und das erfindungsgemäße Verfahren entsprechend vereinfacht. Insbesondere werden keine Daten aus fahrzeugexternen Datenquellen wie die Ladeeinrichtung zwecks Ermittlung des Einsatzzustands der Batterie ausgewertet, sodass eine Fortpflanzung von Datenfehlern aus fahrzeugexternen Fehlerquellen wie die Ladeeinrichtung gänzlich ausgeschlossen wird. Zusätzlich wird vermieden, dass der zwecks Batterieanregung eingestellte Strom insbesondere bei höheren Ladeleistungen stark und unregelmäßig aufgrund der fortlaufenden Datenkommunikation zwischen der externen Ladeeinrichtung und der Ladesteuereinheit des Fahrzeugs variiert. Dies erhöht die Stabilität des elektrisch angeregten Zustands der Batterie und somit die Wiederholbarkeit und -genauigkeit der Batteriediagnose und/oder -analyse.

In einem weiteren Verfahrensschritt werden die erhaltenen OBD-Messdaten ausgewertet, um einen Parameterdatensatz zu zumindest einem Betriebsparameter der Batterie zu erzeugen. Vorzugsweise werden bei der Erzeugung des Parameterdatensatzes ausschließlich die erhaltenen OBD-Messdaten herangezogen. Der zumindest eine Betriebsparameter umfasst eine Kapazität, einen Innenwiderstand der Batterie. Derartige Größen lassen sich beispielsweise mittels Coulomb-Counting (insbesondere Refined Coulomb-Counting) aus den OBD-Messdaten, insbesondere dem Ladezustand der Batterie, gewinnen. Alternativ oder zusätzlich lassen sich Kapazitäten, Ladezustände, Innenwiderstände, Temperaturen, Stromstärken und/oder Spannungen der einzelnen Batteriemodule und/oder Batteriezellen aus den OBD-Messdaten unmittelbar extrahieren. Insbesondere können die OBD-Messdaten nach ihrer Sensorzugehörigkeit unterteilt werden, um jedem Sensor einen eigenen Parameterdatensatz zuzuordnen. Jeder Parameterdatensatz enthält Werte zu einem bestimmten Parameter. Diejenigen Parameterdatensätze, die den Einsatzzustand bzw. Betriebsparameter der Batterie betreffen oder deren Relevanz zum Einsatzzustand der Batterie eine vordefinierte Relevanzschwelle überschreitet, werden aus den insgesamt gewonnenen Parameterdatensätzen selektiert, woraus mehrere jeweils einem Batterie-Betriebsparameter zugeordnete Parameterdatensätze folgen. Alternativ können die OBD-Messdaten zunächst nach ihrer Relevanz zum Einsatzzustand der Batterie vorselektiert werden. Bspw. werden nur diejenigen OBD-Messdaten, deren Relevanz zum Einsatzzustand der Batterie eine vordefinierte Relevanzschwelle überschreitet, vorselektiert. Die vorselektierten OBD-Messdaten werden anschließend nach ihrer Sensorzugehörigkeit unterteilt, woraus mehrere jeweils einem Batterie-Betriebsparameter zugeordnete Parameterdatensätze folgen. Weiter alternativ können zum Einsatzzustand der Batterie relevante Parameterdatensätze (Endparameterdatensätze) durch Weiterverarbeitung der wie vorstehend beschrieben gewonnenen Parameterdatensätze (Rohparameterdatensätze) erhalten werden, etwa um Messfehler und Messungenauigkeiten zu beseitigen, und/oder aus den Rohparameterdatensätzen, die den/die Betriebsparameter der Batterie nur indirekt betreffen, durch geeignete Rechenschritte den/die Betriebsparameter der Batterie direkt betreffende Endparameterdatensätze zu generieren.

Bevorzugt kann die so-bestimmte Kapazität der Batterie (d.h. der so-erzeugte Parameterdatensatz zur Kapazität der Batterie) einer Referenzkapazität (bzw. einem entsprechenden Datensatz) gegenübergestellt und damit verglichen werden ("Mapping"). Auf diese Weise können temperaturbezogene Variationen und/oder Alterung der Kapazität berücksichtigt werden.

In einem weiteren Verfahrensschritt wird aus dem zumindest einen Parameterdatensatz eine Zustandskennzahl der Batterie ermittelt, die den Einsatzzustand der Batterie charakterisiert. Als Zustandskennzahl kann eine Restreichweite, insbesondere eine theoretische Restreichweite (TRR, bzw. "Remaining Useful Life, RUL"), der Batterie, beispielsweise aus dem Parameterdatensatz/den Parameterdatensätzen zum Innenwiderstand bzw. zu den Innenwiderständen der Batterie, ermittelt werden. Die TRR- bzw. RUL-Ergebnisse der Batterie enthalten bevorzugt eine Abschätzung über einen zukünftigen Zeitpunkt, in dem eine kritische Kapazitätsschwelle (die etwa 80% der anfänglichen bzw. vollständigen Kapazität entspricht) erreicht wird. Auch ist es denkbar, dass ein Kapazitätsungleichgewicht zwischen den verschiedenen Batteriemodulen und/oder den verschiedenen Batteriezellen basierend auf den OBD-Messdaten, insbesondere den extrahierten Kapazitätswerten der einzelnen Batteriemodule bzw. Batteriezellen, erhalten wird. Weitere Zustandskennzahlen umfassen einen Überladungsgrad und/oder einen Thermal Runaway-Grad und/oder einen weiteren Gesundheitszustandskennzahl (State of Health, SOH) und/oder die Kapazität in Abhängigkeit von der Temperatur (bzw. Einem spezifischen Kapazitätswert bei einer gegebenen Temperatur) der Batterie.

Die so ermittelte Zustandskennzahl der Batterie kann schließlich über eine Kommunikationsschnittstelle ausgegeben werden. Die Kommunikationsschnittstelle kann zum Beispiel das Steuersystem mit der zentralen Steuereinheit des Fahrzeugs, insbesondere der elektronischen Steuereinheit (Electronic Control Unit, ECU), verbinden, um die Zustandskennzahl(en) zwecks Erzeugung von weiteren Steuersignalen an die ECU bereitzustellen.

Auf diese Weise kann beim Detektieren einer Anomalie in der ermittelten Zustandskennzahl eine Gegenmaßnahme zur Vermeidung von Beeinträchtigungen der Batterie bzw. des Fahrzeugs insgesamt rechtzeitig und wirksam ergriffen werden. Hierdurch wird ein intelligentes Batterieanalyse- und diagnoseverfahren bewerkstelligt, bei dem vorzugsweise ausschließlich OBD-Messdaten herangezogen werden können. Ein Zugriff auf zusätzliche Sensorik ist somit nicht erforderlich, um den Einsatzzustand der Batterie zu bestimmen. Insbesondere entfällt hierdurch die Notwendigkeit, Daten von Ladestationen bzw. Ladesäulen herzuziehen und zu analysieren, sodass die Anzahl der involvierten Datenschnittstellen reduziert wird. Dies führt zur erhöhten Sicherheit und Fehlerbeständigkeit der Batterieanalyse- und Diagnose.

Erfindungsgemäß wird der elektrisch angeregte Zustand der Batterie basierend auf einem Schaltvorgang eines Ladeschützes einer Ladeeinrichtung, an die die Batterie angeschlossen ist, bereitgestellt. Die Ladeeinrichtung kann eine DC-Ladeeinrichtung und/oder eine AC-Ladeeinrichtung umfassen. Die Verwendung des Schaltvorgangs des Ladeschützes der Ladeeinrichtung ist, etwa gegenüber dem aus dem Stand der Technik bekannten Einregeln eines Stroms bzw. Strompulses, dahingehend vorteilhaft, dass der hieraus resultierende angeregte Zustand der Batterie stabiler ist. Insbesondere ergibt sich hieraus ein stabilerer Strompuls, mit dem die Batterie zwecks der elektrischen Anregung beaufschlagbar ist. Außerdem ist die elektrische Anregung der Batterie mit vergleichsweise geringerem Aufwand verbunden, sodass das erfindungsgemäße Verfahren gegenüber dem Stand der Technik vereinfacht ist.

Alternativ oder zusätzlich wird der elektrisch angeregte Zustand der Batterie mittels einer AC-Ladeeinrichtung, an die die Batterie angeschlossen ist, bereitgestellt. Mittels dieser Maßnahme kann vermieden werden, dass die Batteriekühlung trotz Einstellung der Ladeleistung auf Null im DC-Lademodus mittels einer DC-Ladeeinrichtung weiterhin aktiv bleibt, was zu einem unnötigen Stromfluss und damit einhergehend zur geringeren Energieeffizienz führt. Insbesondere im kombinierten Fall, dass ein Schaltvorgang des Ladeschützes der AC-Ladeeinrichtung vorgenommen wird, wird ein elektrisch angeregter Zustand der Batterie mit besonders hoher Zustandsstabilität (insbesondere ein Strompuls mit besonders hoher Pulsstabilität) und somit gesteigerter Wiederholbarkeit und -genauigkeit bei gleichzeitig geringerem Aufwand bewerkstelligt.

Gemäß einer bevorzugten Ausführungsform wird in einem den obigen Verfahrensschritten vorgeschalteten Verfahrensschritt des erfindungsgemäßen Verfahrens zunächst der elektrisch angeregte Zustand der Batterie hergestellt. Alternativ oder zusätzlich werden in einem weiteren vorgeschalteten Verfahrensschritt des erfindungsgemäßen Verfahrens die OBD-Messungen durchgeführt, während sich die Batterie im elektrisch angeregten Zustand befindet, um die OBD-Messdaten zu generieren.

Gemäß einer weiteren bevorzugten Ausführungsform wird in einem den obigen Verfahrensschritten nachgeschalteten Verfahrensschritt des erfindungsgemäßen Verfahrens die ermittelte Zustandskennzahl an eine externe Entität, etwa ein Anzeigegerät (beispielsweise der Touch-Screen eines Mobilgerätes wie Smartphone oder Tablett, oder der Touch-Screen des Fahrzeugs), ausgegeben.

Im Rahmen der vorliegenden Erfindung wird das Steuersystem zur Ermittlung des Einsatzzustands der Batterie des zumindest teilweise elektrifizierten Fahrzeugs vorgeschlagen, wobei das Steuersystem dazu ausgebildet ist, das Verfahren nach einem der hierin beschriebenen Ausführungsformen auszuführen. Das Steuersystem umfasst eine erste Kommunikationsschnittstelle zum Erhalten der OBD-Messdaten, ein Auswertemodul zum Auswerten der OBD-Messdaten und Erzeugen des Parameterdatensatzes/der Parameterdatensätze, ein Ermittlungsmodul zum Ermitteln der Zustandskennzahl basierend auf dem Parameterdatensatz/den Parameterdatensätzen.

Im Rahmen der vorliegenden Erfindung wird ein zumindest teilweise elektrifiziertes Fahrzeug umfassend das erfindungsgemäße Steuersystem vorgeschlagen. Das zumindest teilweise elektrifizierte Fahrzeug kann bspw. ein reinelektrisches Fahrzeug (EV), etwa ein Batterie-Elektrofahrzeug (BEV), oder ein Hybrid-Elektrofahrzeug (HEV) sein. Im Rahmen der vorliegenden Erfindung wird außerdem ein computerlesbares Speichermedium umfassend Befehle vorgeschlagen, die bei der Ausführung durch einen Computer diesen veranlassen, die Schritte des Verfahrens nach einer der im Rahmen dieser Offenbarung beschriebenen Ausführungsformen auszuführen.

Gemäß einer beispielhaften Ausführungsform umfasst der Schaltvorgang des Ladeschützes Einstellen eines Widerstandswertes des Ladeschützes. Der Widerstandswert bezieht sich vorzugsweise auf den Wert eines Vorwiderstands des Ladeschützes. Das Einstellen des Widerstandswertes des Ladeschützes kann kontinuierlich bzw. stufenlos, oder alternativ diskret erfolgen. Bei einem diskreten Einstellprozess nimmt der Widerstandswert des Ladeschützes diskrete Werte (vorzugsweise zusätzlich zu einem vorfestgelegten Maximalwert und dem Wert Null) an oder variiert zwischen den diskreten Werten. Diese Maßnahme ermöglicht eine kontinuierliche bzw. diskrete Einstellmöglichkeit des hieraus resultierenden elektrisch angeregten Zustandes der Batterie, was die Wahrscheinlichkeit erhöht, einen geeigneten angeregten Zustand für die Batterie einzustellen.

Gemäß einer weiteren Ausführungsform umfasst der Schaltvorgang des Ladeschützes Einschalten und/oder Ausschalten und somit Abschalten des Ladeschützes. Das Abschalten des Ladeschützes ermöglicht eine besonders einfache Möglichkeit, einen besonders stabilen elektrisch angeregten Zustand der Batterie, insbesondere einen besonders stabilen Strompuls, mit dem die Batterie zwecks der elektrischen Anregung beaufschlagbar ist, zu bewerkstelligen.

Gemäß einer weiteren beispielhaften Ausführungsform ist die Ladeeinrichtung bzw. die AC-Ladeeinrichtung dazu ausgebildet, eine Stromversorgung für einen im Fahrzeug eingebauten On-Board-Lader (Engl.: On-Board-Charger, OBC) bereitzustellen, der zur elektrischen Anregung der Batterie mit dieser elektrisch verbunden ist. Dies bedeutet, der elektrisch angeregte Zustand der Batterie wird mittels der Ladeeinrichtung bzw. der AC-Ladeeinrichtung in Zusammenwirkung mit dem On-Board-Lader bereitgestellt. Der On-Board-Lader ist vorzugsweise dazu ausgebildet, eine von der AC-Ladeeinrichtung bereitgestellte AC-Spannung in eine DC-Spannung zur elektrischen Anregung der Batterie umzuwandeln. Diese Maßnahme erhöht den Anteil von fahrzeuginternen Komponenten bei der Batteriediagnose und/oder -analyse, die im Vergleich zu fahrzeugexternen Komponenten im Allgemeinen eine höhere Fehlerbeständigkeit aufweisen. Die Zuverlässigkeit des Diagnose- und/oder Analyseergebnisses wird hierdurch erhöht.

Gemäß einer weiteren beispielhaften Ausführungsform ist der Schaltvorgang des Ladeschützes dazu ausgebildet, einen Stromfluss durch den On-Board-Lader auf einen vordefinierten Schwellenwert einzustellen. Dies erfolgt vorzugsweise iterativ, wobei in oder nach jeder Iteration der Schaltvorgang des Ladeschützes bezüglich zumindest eines Schaltparameters geändert und der Stromfluss durch den On-Board-Lader mit dem vordefinierten Schwellenwert verglichen wird. Dieser iterative Prozess wird solange ausgeführt, bis der vordefinierte Schwellenwert erreicht ist. Der vordefinierte Schwellenwert kann Null betragen. Dies bedeutet, der Schaltvorgang des Ladeschützes ist dazu ausgebildet, den On-Board-Lader vollständig stromlos zu schalten. Auf diese Weise verlässt das Fahrzeug den Ladebetrieb, wobei nicht notwendige Nebenverbraucher abgeschaltet werden können. Somit reguliert der On-Board-Lader die Leistung autonom und ganz ohne oder nur mit insignifikanter Interaktion mit externen Systemen/Komponenten. Hieraus resultiert ein vergleichsweise stabiler elektrisch angeregter Zustand der Batterie, insbesondere ein vergleichsweise stabiler Strompuls mit wiederholgenauen Plateaus, mit dem die Batterie zwecks der elektrischen Anregung beaufschlagbar ist.

Gemäß einer weiteren beispielhaften Ausführungsform ist der Schaltvorgang des Ladeschützes der Ladeeinrichtung dazu ausgebildet, einen Strompuls einzustellen, mit dem die Batterie zwecks der elektrischen Anregung beaufschlagbar ist. Insbesondere wird das Ladeschütze der AC-Ladeeinrichtung dahingehend geschaltet, um durch die vorstehend genannte Spannungsumwandlung mittels des On-Board-Laders eine Einstellung des Strompulses vorzunehmen. Somit hängt der einzustellende Strompuls vorzugsweise unmittelbar mit der vom On-Board-Lader gelieferten Ausgangsspannung zusammen. Dieser Einstellvorgang ist vorzugsweise iterativ, wobei in oder nach jeder Iteration zumindest ein Schaltparameter des Ladeschützes geändert wird und hierauf basierend der daraus folgende Ist-Wert mit dem Sollwert des Strompulses verglichen wird. Als Schaltparameter können beispielsweise die Schaltzeit, die Schaltperiode, die Schaltfrequenz, die Anzahl der Schaltvorgänge, die Pulsform (etwa Pulshöhe und/oder Pulsbreite) oder ein anderer Schaltparameter herangezogen werden. Dies wird solange durchgeführt, bis der Sollwert bis auf möglicherweise vorhandene Messtoleranz erreicht ist. Durch das Schalten des Ladeschützes der Ladeeinrichtung, insbesondere der AC-Ladeeinrichtung, lässt sich erfindungsgemäß ein gleichmäßigerer und stabilerer Stromimpuls mit klaren Plateaus erzeugen, was die Bestimmung des Innenwiderstandes der Batterie deutlich erleichtert und damit einhergehend die Wiederholgenauigkeit der Batteriediagnose und/oder -analyse signifikant verbessert.

Gemäß einer weiteren beispielhaften Ausführungsform ist der Schaltvorgang des Ladeschützes dazu ausgebildet, einen gleichmäßigen Strompuls zu generieren. Die Gleichmäßigkeit des Strompulses kann sich auf einen Pulsparameter des Strompulses, etwa Pulsdauer, Pulsperiode, Pulshöhe, Pulsbreite, Pulsform beziehen. Insbesondere kann sich die Gleichmäßigkeit daran festgelegt werden, inwieweit sich der Pulsparameter über einen Zeitabstand zwischen zwei benachbarten Strompulssignalen oder zwischen zwei benachbarten Strompulsgruppen je umfassend mehrere Strompulssignale verändert. Hierbei weist der Strompuls eine umso höhere Gleichmäßigkeit auf, je konstanter der Pulsparameter ist. Die Gleichmäßigkeit kann in Abhängigkeit von zumindest zwei der vorgenannten Faktoren bestimmt werden, wobei diese Faktoren gewichtet sein können. Es ist denkbar, den gleichmäßigen Strompuls mittels eines iterativen Prozesses zu generieren. Dabei kann in oder nach jeder Iteration die Gleichmäßigkeit des resultierenden Strompuls mit einer vordefinierten Schwelle verglichen werden und, solange Letztere noch nicht erreicht ist, eine Änderung/Anpassung eines oder mehrerer Schaltparameter des Schaltvorgangs des Ladeschützes durchgeführt werden. Auf diese Weise kann ein Strompuls zur elektrischen Anregung der Batterie mit der gewünschten hohen Stabilität zuverlässig bereitgestellt werden.

Gemäß einer weiteren beispielhaften Ausführungsform wird der Schaltvorgang des Ladeschützes basierend auf einem Schaltsignal initiiert, welches von einer Antriebssteuereinheit des Fahrzeugs, welche zur Ansteuerung eines elektrischen Achsantriebs ausgebildet ist, und/oder von einer elektronischen Steuereinheit des Fahrzeugs erzeugt. Die Antriebssteuereinheit ist vorzugsweise dazu ausgebildet, einen halbleiterbasierten Umrichter, insbesondere einen DC/AC-Wechselrichter zur Umwandlung einer von der Batterie bereitgestellten DC-Spannung in eine AC-Spannung zur Bestromung des elektrischen Achsantriebs, einen AC/DC-Gleichrichter zur Umwandlung einer AC-Eingangsspannung in eine DC-Ausgangsspannung, vorzugsweise zur Aufladung der Batterie, anzusteuern. Auf diese Weise kann der Schaltvorgang mittels bereits vorhandener Steuereinheit(en) initiiert werden, sodass keine zusätzliche Steuereinheit benötigt wird. Dies ermöglicht nicht nur eine Bauraumeinsparung, sondern auch einen zuverlässigen Schaltvorgang des Ladeschützes und eine sichere elektrische Anregung der Batterie.

Gemäß einer weiteren beispielhaften Ausführungsform wird der elektrisch angeregte Zustand der Batterie mit Hilfe eines Ladezykluses und/oder eines Entladezykluses der Batterie hergestellt. Insbesondere umfasst der Strompuls zur elektrischen Anregung der Batterie einen Ladestrompuls des Ladezykluses und/oder einen Entladestrompuls des Entladezykluses. Der Ladezyklus und/oder der Entladezyklus weist eine Maximaldauer von vorzugsweise 15 Minuten, weiter vorzugsweise 10 Minuten, weiter vorzugsweise 5 Minuten auf. Der Ladezyklus bzw. Entladezyklus wird vorzugsweise durch die Ladeeinrichtung, vorzugsweise die AC-Ladeeinrichtung, an die die Batterie angeschlossen ist, bereitgestellt. Vorzugsweise stellt die Ladeeinrichtung auf ein Triggersignal des Steuersystems hin den Ladezyklus und/oder den Entladezyklus bereit. Alternativ oder zusätzlich kann das Triggersignal auf der Benutzeroberfläche (User Interface, UI), welche auf dem Anzeigeelement (etwa Touch-Screen) des Mobilgerätes bereitgestellt wird, erzeugt werden, indem ein hierfür vorgesehenes virtuelles Kontrollelement wie eine virtuelle Triggertaste oder ein virtueller Triggerknopf auf dem Anzeigeelement bzw. Touch-Screen berührend bestätigt wird. Hierdurch lässt sich die Batterie auf vereinfachte und zugleich sichere Weise elektrisch anregen, sodass die Batterieanalyse und -diagnose erleichtert ist.

Gemäß einer weiteren beispielhaften Ausführungsform erfolgt die Auswertung der OBD-Messdaten und/oder die Ermittlung der Zustandskennzahl unter Verwendung eines algorithmischen Modells, vorzugsweise eines neuronalen Netzwerkmodells (NN-Modells), insbesondere eines Machine-Learning-Modells (ML-Modells). Die OBD-Messdaten, insbesondere betreffend den SOC, die Temperatur, das Coulomb-Counting (CC-Daten), den früheren Lade- und/oder Entladeprozess, den Strom und/oder die Spannung der Batterie, werden ins algorithmische Modell, insbesondere das NN- bzw. ML-Modell, eingegeben. Vorzugsweise erzeugt das Modell hierauf basierend die aktuelle Kapazität der Batterie, wobei das Modell ferner vorzugsweise die aktuelle Kapazität einer vorbestimmten Referenzkapazität gegenüberstellt, um einen Vergleich und/oder ein "Mapping" durchzuführen. Das Modell ist vorzugsweise vortrainiert und validiert. Des Weiteren ermittelt das algorithmische Modell, insbesondere das NN- bzw. ML-Modell, aus der Kapazität und/oder dem Innenwiderstand den Gesundheitszustand (SOH).

Gemäß einer bevorzugten Ausführungsform umfasst das algorithmische Modell bzw. das NN-/ML-Modell ein Datenbereinigungsmodul, welches dazu ausgebildet ist, die OBD-Messdaten um ungültige Daten (bzw. Datenpunkte) zwecks Sicherstellung der Datenqualität zu bereinigen. Dazu ist das algorithmische Modell bzw. das NN-/ML-Modell beispielsweise dazu ausgebildet, SOC-Unregelmäßigkeiten wie Diskontinuitäten und/oder übersprungene SOC-Messschritte ("SOC steps") aus den OBD-Messdaten zu detektieren und optional zu entfernen. Alternativ oder zusätzlich ist das algorithmische Modell bzw. das NN-/ML-Modell dazu ausgebildet, Datenpunkte, bei denen das Messzeitintervall (d.h. das Zeitintervall zwischen zwei aufeinanderfolgenden Messungen) zu vernachlässigen.

Gemäß einer weiteren bevorzugten Ausführungsform umfasst das algorithmische Modell ein Vorprozessierungsmodul, um die bereits um ungültige Daten bzw. Datenpunkte bereinigten OBD-Messdaten vorzuprozessieren. Die Vorprozessierung dient beispielsweise dazu, (übrig gebliebene) fehlerbehaftete Datenpunkte zu beseitigen und/oder die OBD-Messdaten auf die Eingabe in ein Machine-Learning-Modul (ML-Modul) vorzubereiten (d.h. das ML-Modul ist ein weiteres Modul des gesamten ML-Modells). Alternativ oder zusätzlich ist das Vorprozessierungsmodul dazu ausgebildet, Pulsmessungen ("pulse measurements") durchzuführen, um sogenannte "virtuel edges" zu erzeugen, die zur Extraktion von Schlüsselmerkmalen verwendet werden, die auf den Gesundheitszustand der Batterie hinweisen.

Gemäß einer bevorzugten Ausführungsform ist das ML-Modell als ein "gemischtes" bzw. kombiniertes ML-Modell ausgebildet, welches mehrere Sub-ML-Modelle umfasst. Diese Maßnahme erhöht die Genauigkeit der Batteriediagnose und/oder - prognose. Beispielsweise kann eines der Sub-ML-Modelle ein erstes Schätzer-Modell umfassen, welches einen zukünftigen Zeitpunkt abschätzt, bei dem die Batteriekapazität auf 80% ihres anfänglichen Wertes bzw. ihres Gesamtwertes fallen und somit den sogenannten C80-Zustand erreichen wird. Diese Schätzung dient somit als ein Indikator für die Restlebensdauer der Batterie. Alternativ oder zusätzlich kann eines der Sub-ML-Modelle ein zweites Schätzer-Modell umfassen, welches die Alterungsrate der Batterie für Fahrzeuge abschätzt, bei denen der C80-Zustand noch nicht erreicht ist. Eine Zusammenführung der beiden obigen Sub-ML-Modelle ist dazu in der Lage, eine besonders zuverlässige SOH-Vorhersage unabhängig von aktuellem Fahrzeugzustand und verfügbaren Daten zu treffen.

Gemäß einer weiteren bevorzugten Ausführungsform ist das ML-Modell zum Transferlernen ("transfer learning") ausgebildet. Mittels des Transferlernens ist das ML-Modell dazu in der Lage, basierend auf eingegebenen OBD-Messdaten eines ersten Fahrzeug- und/oder Batterietyps einen oder mehrere Parameterdatensätze (etwa betreffend Kapazität und/oder Innenwiderstand) eines zweiten Fahrzeug- und/oder Batterietyps zu generieren. Dies erfolgt vorzugsweise dadurch, dass der Fahrzeug- und/oder Batterietyp als einer der Parameter ins zum Transferlernen trainierte ML-Modell eingegeben wird (bzw. dass die ersten und zweiten Fahrzeug- und/oder Batterietypen ins zum Transferlernen trainierte ML-Modell eingegeben werden). Das ML-Modell ist insbesondere durch das Trainieren auf Transferlernen dazu ausgebildet, eine Anpassung der Parameterdatensätze des ersten Fahrzeug- und/oder Batterietyps basierend auf einen Unterschied zwischen beiden Fahrzeug- bzw. Batterietypen durchzuführen. Dazu kann eine Look-Up-Table (LUT) oder eine andere Datenbank herangezogen werden, in der Anpassungsfaktoren zwischen dem ersten Fahrzeug- bzw. Batterietyp und dem zweiten Fahrzeug- bzw. Batterietyp vordefiniert sind. Auf diese Weise ist möglich, eine Analyse und/oder Diagnose der aktuellen Batterie mit hinreichender Genauigkeit durchzuführen, selbst wenn lediglich auf einen von der aktuellen Batterie verschiedenen Batterietypen bezogene und somit limitierte OBD-Messdaten verfügbar sind.

Gemäß einer weiteren bevorzugten Ausführungsform ist das ML-Modell dazu ausgebildet, eine Wahrscheinlichkeitslogik ("probabilistic logic" oder "probabilistic reasoning") zu involvieren. Die Wahrscheinlichkeitslogik wird insbesondere dazu verwendet, Konfidenzintervalle hinsichtlich der erzeugten Parameterdatensätze (etwa betreffend Kapazität und/oder Innenwiderstand), insbesondere durch Berücksichtigung von Unsicherheiten bzw. Toleranzen in den OBD-Messdaten und/oder im ML-Modell zu ermitteln. Hierzu werden bevorzugt Bayesianische neuronale Netzwerke eingesetzt, die basierend auf der Qualitäts- und/oder Vollständigkeitsstufe der OBD-Messdaten Einsichten in die Unsicherheit der Vorhersage über die Restlebensdauer der Batterie bieten und für eine solche Vorhersage somit besonders geeignet sind.

Gemäß einer weiteren bevorzugten Ausführungsform ist das algorithmische Modell, insbesondere das NN- bzw. ML-Modell, mit einem Feedback-Mechanismus ausgestattet, um die Erzeugung der Parameterdatensätze, die Ermittlung der Zustandskennzahl und/oder eine Alterungsprognose kontinuierlich hinsichtlich Genauigkeit zu optimieren. Der Feedback-Mechanismus kann alternativ oder zusätzlich dazu ausgestaltet sein, das ML-Modell anhand von realen Daten ("Real World Data") bzw. basierend auf Vergleichsergebnisse mit realen Daten anzupassen, wobei das ML-Modell optional mit Parameterdatensätzen (etwa betreffend Kapazität und/oder Innenwiderstand der Batterie), die mit dem angepassten ML-Modell gewonnen sind, erneut zu trainieren.

Gemäß einer weiteren beispielhaften Ausführungsform wird neben den OBD-Messdaten zumindest eine Quereinflussinformation zur Auswertung der OBD-Messdaten berücksichtigt. Dies bedeutet, dass der Parameterdatensatz zum zumindest einen Betriebsparameter der Batterie basierend auf den OBD-Messdaten und der Quereinflussinformation erzeugt wird. Alternativ oder zusätzlich wird die Quereinflussinformation bei der Ermittlung der Zustandskennzahl berücksichtigt. Dies bedeutet, dass die Zustandskennzahl basierend auf dem Parameterdatensatz und zusätzlich der Quereinflussinformation ermittelt wird. Die Quereinflussinformation umfasst zumindest eine der folgenden Informationen: eine Temperatur und/oder eine Temperaturverteilung der Batterie und/oder des Fahrzeugs, eine Fahrzeugmodellinformation des Fahrzeugs, eine Laufleistung/ein Kilometerstand des Fahrzeugs, ein geografischer Standort des Fahrzeugs, vorbestimmte Alterungswerte wie Alterungsrate der Batterie, OBD-Messdaten vergleichbarer Batterietypen, Temperaturänderungen/-schwankungen während der OBD-Messung, ein und/oder ein Batteriemanagementsystem(BMS)-Parameter. Die Berücksichtigung der Quereinflussinformation kann erfolgen, indem der erzeugte Parameterdatensatz bzw. die erzeugten Parameterdatensätze basierend auf der Quereinflussinformation korrigiert wird/werden. Alternativ können die OBD-Messdaten und die Quereinflussinformation in Kombination dem zumindest einem Parameterdatensatz zugrunde gelegt werden. Durch die Berücksichtigung der Quereinflussinformation(en) kann der zumindest eine Parameterdatensatz zum Betriebsparameter der Batterie und damit einhergehend die Zustandskennzahl der Batterie mit höherer Präzision bereitgestellt werden. Die Batterieanalyse und - diagnose wird somit zuverlässiger.

Gemäß einer weiteren beispielhaften Ausführungsform erfolgt die Berücksichtigung der Quereinflussinformation unter Verwendung des NN-Modells, insbesondere des ML-Modells. Beispielsweise kann der erzeugte Parameterdatensatz und die Quereinflussinformation in das NN-Modell bzw. das ML-Modell eingegeben, um einen korrigierten bzw. angepassten Parameterdatensatz zu erzeugen. Alternativ können OBD-Messdaten und die Quereinflussinformation ins NN-Modell bzw. ML-Modell eingegeben werden, um einen die Quereinflussfaktoren berücksichtigenden Parameterdatensatz zum zumindest einen Betriebsparameter zu erzeugen. Das NN-Modell bzw. ML-Modell ist vorzugsweise mit Trainingsdaten, die die verschiedenen Arten von Quereinflussinformationen betreffen, vortrainiert. Es kann sich hierbei insbesondere um ein Large-Language-Modul (LLM-Modul) des gesamten NN- bzw. ML-Modells handeln, das dazu trainiert wurde, aus einer teilweise oder vollständig semantischen Aufgabenbeschreibung einen vorgespeicherten Datensatz betreffend eine Quereinflussinformation aus einem geeigneten Speichermedium zu extrahieren, und die OBD-Messdaten bzw. den zumindest einen Parameterdatensatz basierend auf der Quereinflussinformation anzupassen. Ein solches LLM umfasst mehrere Neuronenschichten, die gemäß einer Transformer-Architektur mit Encodern und Decodern, vorzugsweise zusätzlich mit einem Selbstaufmerksamkeitsmechanismus, aufgebaut sind. Durch die Verwendung des NN- bzw. des ML-Modells (etwa des LLM-Moduls) können die OBD-Messdaten oder alternativ der aus den OBD-Messdaten erzeugte zumindest eine Parameterdatensatz zum Betriebsparameter der Batterie präziser und effizienter auf die Quereinflussinformation angepasst werden.

Gemäß einer weiteren beispielhaften Ausführungsform umfasst das Verfahren ferner Schätzen eines Alters, einer Alterungsrate und/oder einer Restlebensdauer ("Remaining Useful Life", RUL) der Batterie basierend auf der ermittelten Zustandskennzahl. Dies erfolgt vorzugsweise unter Verwendung des algorithmischen Modells, insbesondere des NN-Modells bzw. des ML-Modells. Dazu kann die ermittelte Zustandskennzahl an ein Schätzungsmodul des Steuersystems ausgegeben werden, welches hierauf basierend das Alter, die Alterungsrate und/oder die Restlebensdauer der Batterie berechnet. Hierdurch wird das Resultat der Batterieanalyse- und Diagnose um eine Alterungsprognose erweitert bzw. vervollständigt. Alternativ kann die Alterungsprognose (die Alterungsrate und/oder die Restlebensdauer) direkt aus dem erzeugten Parameterdatensatz bzw. den erzeugten Parameterdatensätzen, insbesondere betreffend die Kapazität und/oder den Innenwiderstand der Batterie, ermittelt werden. Hierbei ist denkbar, Alterungsdaten (etwa Alterungskurven, die jeweils eine zeitliche Funktion der Alterungsrate umfassen) einer externen Batterie, insbesondere eines vergleichbaren oder gleichen Batterietyps, zu berücksichtigen bzw. als zusätzliche Eingabedaten in das NN-Modell bzw. das ML-Modell zu integrieren. Dies ermöglicht das Bestimmen einer zukünftigen Entwicklungstrajektorie der Kapazität (insbesondere den Verlauf des Kapazitätsverlustes in zeitlicher Abhängigkeit) und/oder des Innenwiderstands der Batterie. Außerdem ist hierdurch ein direkter Vergleich der Alterungscharakteristik des betroffenen Fahrzeugs mit einer durchschnittlichen Alterungscharakteristik eines vergleichbaren Fahrzeugs (etwa eines vergleichbaren Fahrzeugtyps) ermöglicht, um eventuelle Anomalien der Batterie festzustellen. Die Daten der Alterungsprognose können außerdem als zusätzliche Trainingsdaten zu weiterem Optimieren des NN-Modells bzw. des ML-Modells eingesetzt werden, um die Genauigkeit der Alterungsprognose zu verbessern. Der Zustand, bei dem die Batterie 80% ihrer Gesamtkapazität (bzw. ihrer anfänglichen Kapazität) erreicht wird (d.h. der C80-Zustand) und/oder die Restlebensdauer der Batterie kann beispielsweise mit erhöhter Zuverlässigkeit detektiert/bestimmt werden. Vorzugsweise kann diese Alterungsprognose wahlweise durchgeführt werden, indem nach der Ermittlung der Zustandskennzahl(en) mehrere Optionen zur Verfügung gestellt werden: eine erste Option, bei der keine Alterungsprognose durchgeführt und die ermittelte Zustandskennzahl ausgegeben wird; eine zweite Option, bei der die Alterungsprognose basierend auf der ermittelten Zustandskennzahl durchgeführt wird, wobei das Resultat der Alterungsprognose entweder nach der Ausgabe der Zustandskennzahl oder gleichzeitig dazu ausgegeben wird.

Gemäß einer weiteren bevorzugten Ausführungsform umfasst das Steuersystem ein Triggermodul zum Herstellen des elektrisch angeregten Zustands der Batterie durch die Ladeeinrichtung, und/oder ein Startmodul zum Starten der OBD-Messungen durch das OBD-System. Insbesondere ist das Triggermodul dazu ausgebildet, einen Schaltvorgang des Ladeschützes der AC- und/oder DC-Ladeeinrichtung auszuführen, an die die Batterie angeschlossen ist, um den elektrisch angeregten Zustand der Batterie herzustellen. Alternativ oder zusätzlich ist das Triggermodul dazu ausgebildet, die AC-Ladeeinrichtung dahingehend anzusteuern, um den elektrisch angeregten Zustand der Batterie herzustellen. Optional kann das Steuersystem zusätzlich ein Schätzungsmodul zum Schätzen des Alters, der Alterungsrate und/oder der Restlebensdauer basierend auf der Zustandskennzahl/den Zustandskennzahlen umfassen.

Gemäß einer weiteren bevorzugten Ausführungsform ist das Steuersystem zumindest teilweise, vorzugsweise vollständig, auf einem Mobilgerät, beispielsweise einem Smartphone und/oder einem Tablett, welches weiter vorzugsweise einen Touch-Screen aufweist, oder alternativ in einem Fahrzeug oder einem Server, etwa einem Cloud-Server bereitgestellt. Insbesondere kann zumindest eines der o.g. Module und/oder Kommunikationsschnittstelle des Steuersystems auf einer der o. g. Entitäten bereitgestellt sein. Das OBD-System kann, nachdem der elektrisch angeregte Zustand der Batterie stabil hergestellt ist, auf ein Startsignal des Steuersystems hin mit der Durchführung der OBD-Messungen beginnen. Das Startsignal kann auf einer Benutzeroberfläche (User Interface, UI), welche auf einem Anzeigeelement (etwa dem Touch-Screen) des Mobilgerätes oder des Fahrzeugs bereitgestellt wird, erzeugt werden, indem ein hierfür vorgesehenes virtuelles Kontrollelement wie eine virtuelle Starttaste oder ein virtueller Startknopf auf dem Anzeigeelement bzw. Touch-Screen berührend bestätigt wird. Aus diesen OBD-Messungen werden die OBD-Messdaten erzeugt, die typischerweise Werte zu den erfassten Parametern enthalten. Die OBD-Messdaten werden per Peripheriegeräte ausgelesen und über die Kommunikationsschnittstellen an ein Auswertemodul des Steuersystems geführt.

Die oben genannten Aspekte dienen illustrativen Zwecken und sind nicht dazu gedacht, den Umfang der Erfindung einzuschränken. Zahlreiche Variationen der oben beschriebenen Aspekte sind möglich. Die verschiedenen in der vorliegenden Offenbarung diskutierten Aspekte können beliebig kombiniert werden, um zusätzliche Vorteile hervorzubringen. Darüber hinaus können einige der Merkmale die Grundlage für eine oder mehrere Teilanmeldungen bilden.

Die Erfindung wird nachstehend anhand von Beispielen unter Verwendung der in den Figuren gezeigten Ausführungsformen erläutert. Es zeigen:
Fig. 1 eine schematische Darstellung eines zumindest teilweise elektrifizierten Fahrzeugs;
Fig. 2 eine schematische Darstellung einer Anordnung umfassend eine Ladeeinrichtung, ein On-Board-Diagnose (OBD)-System und ein Steuersystem zur Ermittlung eines Einsatzzustands einer Batterie des Fahrzeugs;
Fig. 3 eine schematische Darstellung des Steuersystems gemäß einer Ausführungsform;
Fig. 4 eine schematische Darstellung der Ladeeinrichtung umfassend ein Ladeschütze;
Fig. 5 eine schematische Darstellung eines Verfahrens zur Ermittlung des Einsatzzustands der Batterie des Fahrzeugs gemäß einer Ausführungsform;
Fig. 6 eine schematische Darstellung eines Verfahrens zur Ermittlung des Einsatzzustands der Batterie des Fahrzeugs gemäß einer weiteren Ausführungsform.

Die gleichen Objekte, funktionale Einheiten und vergleichbare Komponenten sind in den Figuren mit denselben Bezugsnummern versehen. Diese Objekte, funktionale Einheiten und vergleichbaren Komponenten sind hinsichtlich ihrer technischen Merkmale identisch, es sei denn, die Beschreibung explizit oder implizit etwas anderes offenbart.

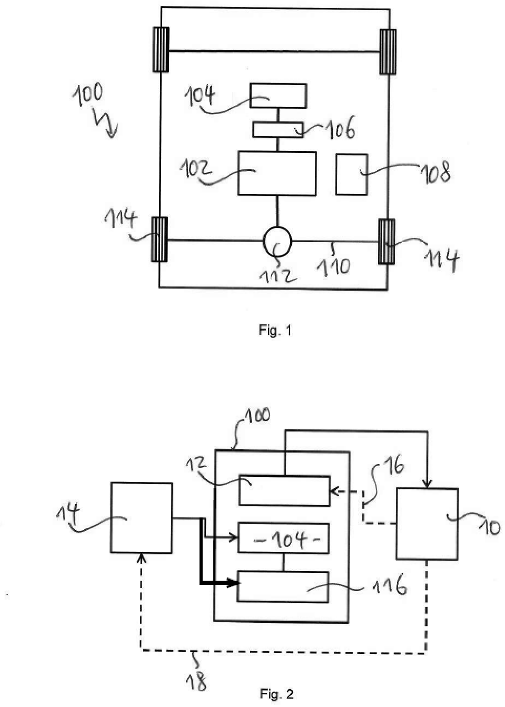

Fig. 1 zeigt eine schematische Darstellung eines zumindest teilweise elektrifizierten Fahrzeugs 100. Das Fahrzeug 100 kann ein reines Elektrofahrzeug oder ein Hybridfahrzeug aufweisen. Das Fahrzeug 100 ist mit einem elektrischen Achsantrieb umfassend einen Elektromotor 102, einen DC/AC-Wechselrichter 106 und ein Getriebe 112 ausgebildet. Der Elektromotor 100 umfasst einen Stator mit mehreren als Statorwicklungen vorliegenden Phasensträngen und einen Rotor, der magnetisch wirkt. Der Wechselrichter 106 ist zwecks Umwandlung einer durch eine Antriebsbatterie 104 bereitgestellten DC-Eingangsspannung in eine AC-Ausgangsspannung zwischen der Antriebsbatterie 104 und dem Elektromotor 102 verschaltet. Dazu weist der Wechselrichter 106 eine Mehrzahl von hier nicht näher gezeigten Leistungsschaltern auf, die eine Brückenschaltung mit mehreren Halbbrücken bilden und mit von einem Steuergerät 108 generierten Steuersignalen ansteuerbar sind. Das Steuergerät 108 kann eine zentrale Steuereinheit, etwa die elektronische Steuereinheit (Electronic Control Unit, ECU) des Fahrzeugs 100 oder ein Bestandteil hiervon sein. Die Steuersignale sind vorzugsweise dazu ausgebildet, die Leistungsschalter des Wechselrichters 106 gemäß einer Pulsweitenmodulation (PWM) zu schalten. Insbesondere werden durch Öffnen und Schließen der Leistungsschalter mehrere vorzugsweise zeitlich sinusförmig verlaufende und voneinander phasenverschobenen Phasenströme je für einen der Phasenstränge erzeugt. Die Phasenströme, die jeweils in eine der mehreren Phasenstränge eingespeist werden, bewirken im Innenbereich des Stators ein rotierendes Magnetfeld, welches den magnetischen Rotor in Drehbewegung versetzt. Auf diese Weise wird ein Drehmoment durch den Elektromotor 102 erzeugt, welches über das Getriebe 112 an eine Achse 110 (hier beispielhaft als Hinterachse vorliegend) und schließlich an Räder 114 (hier beispielhaft als Hinterräder vorliegend) übertragen wird.

Die Antriebsbatterie 104 kann als Lithium-Ionen-Batterie, insbesondere Lithiumtitanat-Akkumulatoren (LTO), Lithium-Cobaltdioxid-Akkumulatoren (LCO), Lithium-Mangan-Akkumulatoren (LMO, LNMO), Lithium-Polymer-Akkumulatoren, Lithium-Eisenphosphat-Akkumulatoren (LFP), Lithium-Luft-Akkumulatoren oder Zinn-Schwefel-Lithium-Ionen-Akkumulatoren ausgebildet sein. Die Antriebsbatterie 104 kann als Batteriesystem umfassend eine Vielzahl von Batteriemodulen ausgebildet sein, wobei jedes Batteriemodul wiederum mehrere Batteriezellen umfasst. Für die Funktionalität des Fahrzeugs 100 ist es wichtig, einen positiven Einsatzzustand der Antriebsbatterie 104 sicherzustellen. Dazu soll eine Batterieanalyse und -diagnose dienen.

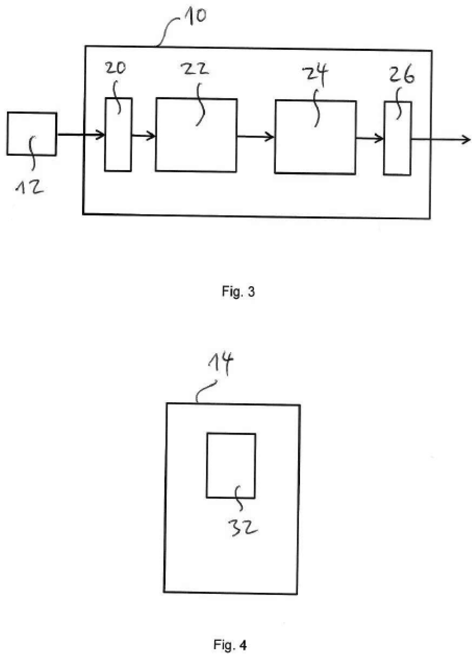

Fig. 2 zeigt eine schematische Darstellung eine Anordnung zur Ermittlung des Einsatzzustands der Antriebsbatterie 104 mit einem Steuersystem 10, welches in Zusammenwirkung mit einem On-Board-Diagnose(OBD)-System 12 steht. Das Steuersystem 10, welches in Fig. 3 näher gezeigt ist, ist vorzugsweise in einem vom Fahrzeug 100 unabhängigen Mobilgerät wie Smartphone oder Tablett (hier nicht gezeigt) realisiert. Alternativ kann das Steuersystem 10 im Fahrzeug 100 verbaut sein (hier nicht gezeigt), etwa als Bestandteil des Steuergeräts 108 (siehe Fig. 1) oder steht mit Letzterem in datenkommunikativer Verbindung. Das OBD-System 12, welches ins Fahrzeug 100 integriert ist, umfasst mehrere hier nicht näher gezeigte Sensoren, die jeweils zur Erfassung eines Parameters des Fahrzeugs 100 im Fahrbetrieb ausgebildet sind. Das OBD-System 12 kann unabhängig vom Steuersystem 10 die OBD-Messungen durchführen. Alternativ kann das OBD-System 12 basierend auf einem Startsignal 16 des Steuersystems 10 die OBD-Messungen durchführen. Aus diesen OBD-Messungen resultieren OBD-Messdaten, die an das Steuersystem 10 weitergeleitet werden.

Wie in Fig. 3 rein schematisch und beispielhaft gezeigt, weist das Steuersystem 10 eine erste Kommunikationsschnittstelle 20 auf, die als Dateneingang zum Empfangen von OBD-Messdaten des OBD-Systems 12 ausgebildet ist. Das Steuersystem 10 weist auch ein Auswertemodul 22 zur Auswertung der OBD-Messdaten auf, wobei das Auswertemodul 22 basierend auf dem Auswertungsergebnis der OBD-Messdaten einen Parameterdatensatz zu zumindest einem Betriebsparameter der Antriebsbatterie 104 erzeugt. Das Steuersystem 10 weist ferner ein Ermittlungsmodul 24 zur Ermittlung einer den Einsatzzustand der Antriebsbatterie 104 charakterisierenden Zustandskennzahl aus dem Parameterdatensatz/den Parameterdatensätzen auf. Das Steuersystem 10 weist schließlich eine zweite Kommunikationsschnittstelle 26 auf, die als Datenausgang des Steuersystems 10 fungiert, um die ermittelte Zustandskennzahl an eine externe Entität auszugeben.

Des Weiteren ist eine fahrzeugexterne Ladeeinrichtung 14 zur Anregung der Antriebsbatterie 104 an diese angeschlossen, wie in Fig. 2 rein schematisch gezeigt. Die Ladeeinrichtung 14 ist hier vorzugsweise als AC-Ladeeinrichtung, etwa eine Ladestation bzw. Ladesäule, ausgebildet. Die AC-Ladeeinrichtung 14, die in Fig. 4 schematisch und beispielhaft näher gezeigt ist, weist ein Ladeschütze 32 auf. Das Ladeschütze 32 ist dazu schaltbar, einen Strompuls zu erzeugen, mit welchem die Antriebsbatterie 104 zwecks elektrischer Anregung beaufschlagt werden kann. Dazu ist die AC-Ladeeinrichtung 14 mit einer im Fahrzeug 100 integrierter On-Board-Lader (On-Board-Charger, OBC) 116 verbunden, der wiederum mit der Antriebsbatterie 104 verschaltet ist. Die AC-Ladeeinrichtung 14 ist dazu ausgebildet, eine AC-Spannung zu erzeugen. Gleichzeitig ist der On-Board-Lader dazu ausgebildet, die von der AC-Ladeeinrichtung 14 bereitgestellte AC-Spannung in eine DC-Spannung umzuwandeln, mit der der Strompuls erzeugt wird. Die AC-Ladeeinrichtung 14 kann nach Empfangen eines durch das Steuersystem 10 generierten Triggersignals 18 (siehe Fig. 2), welches ein Schaltsignal enthält, das Schalten des Ladeschützes 32 initiieren. Hierauf basierend wird über die Spannungsumwandlung durch den On-Board-Lader 116 ein Strompuls erzeugt. Die Batterie 104 wird mit dem erzeugten Strompuls beaufschlagt, um den elektrisch angeregten Zustand der Batterie 104 bereitzustellen.

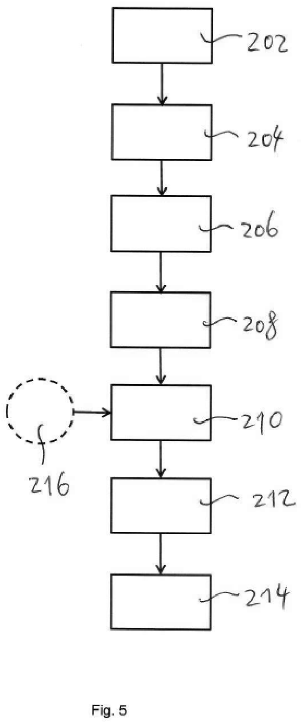

Fig. 5 zeigt eine schematische Darstellung eines Verfahrens zur Ermittlung des Einsatzzustands der Antriebsbatterie 104 gemäß einer beispielhaften Ausführungsform. In einem ersten Verfahrensschritt 202 wird das Ladeschütz 32 der AC-Ladeeinrichtung 14 zwecks elektrischer Anregung der Antriebsbatterie 104 geschaltet. Der Schaltvorgang des Ladeschützes 32, der einen Einschaltvorgang und/oder eine Ausschaltvorgang des Ladeschützes 32 vorzugsweise umfasst, kann beispielsweise dazu dienen, einen Strompuls, insbesondere einen vordefinierten Strompuls (Sollwert), einzustellen, mit dem die Antriebsbatterie 104 beaufschlagt wird und basierend auf dem die Batterieanregung erfolgt. Insbesondere wird der Strompuls basierend auf Umwandlung einer von der AC-Ladeeinrichtung 14 erzeugten AC-Spannung in eine DC-Spannung durch den On-Board-Lader 116 generiert, bzw. eingestellt. Dieser Einstellvorgang ist vorzugsweise iterativ, wobei in oder nach jeder Iteration zumindest ein Schaltparameter geändert wird und hierauf basierend der daraus folgende Ist-Wert mit dem Sollwert des Strompulses verglichen wird. Als Schaltparameter können beispielsweise die Schaltzeit, die Schaltperiode, die Schaltfrequenz, die Anzahl der Schaltvorgänge oder ein anderer Schaltparameter herangezogen werden. Dies wird solange durchgeführt, bis der Sollwert bis auf eine möglicherweise vorhandene Messtoleranz erreicht ist.

In einem weiteren Verfahrensschritt 204 wird basierend auf dem Ergebnis des Schaltvorgangs, insbesondere des eingestellten Strompuls, die Antriebsbatterie 104 elektrisch angeregt. Dies erfolgt insbesondere indem die Antriebsbatterie 104 mit dem erzeugten Strompuls beaufschlagt wird. Der On-Board-Lader 116, der an die Antriebsbatterie 104 angeschlossen ist, stellt den erzeugten bzw. eingestellten Strompuls an die Antriebsbatterie 104 bereit.

Der Schaltvorgang des Ladeschützes 32 kann dazu ausgebildet sein, einen gleichmäßigen Strompuls zu generieren. Die Gleichmäßigkeit des Strompulses kann sich auf einen Pulsparameter des Strompulses, etwa Pulsdauer, Pulsperiode, Pulshöhe, Pulsbreite, Pulsform beziehen. Insbesondere kann sich die Gleichmäßigkeit daran festgelegt werden, inwieweit sich der Pulsparameter über einen Zeitabstand zwischen zwei benachbarten Strompulssignalen oder zwischen zwei benachbarten Strompulsgruppen je umfassend mehrere Strompulssignale verändert. Hierbei weist der Strompuls eine umso höhere Gleichmäßigkeit auf, je konstanter der Pulsparameter ist. Die Gleichmäßigkeit kann in Abhängigkeit von zumindest zwei der vorgenannten Faktoren bestimmt werden, wobei diese Faktoren gewichtet sein können.

Es ist denkbar, den gleichmäßigen Strompuls mittels eines iterativen Prozesses zu generieren. Dabei kann in oder nach jeder Iteration die Gleichmäßigkeit des resultierenden Strompuls mit einer vordefinierten Schwelle verglichen werden und, solange Letztere noch nicht erreicht ist, eine Änderung/Anpassung eines oder mehrerer Schaltparameter des Schaltvorgangs des Ladeschützes 32 durchgeführt werden. Auf diese Weise kann ein Strompuls zur elektrischen Anregung der Antriebsbatterie 104 mit der gewünschten hohen Stabilität zuverlässig bereitgestellt werden.

Der Schaltvorgang des Ladeschützes 32 kann alternativ oder zusätzlich basierend auf einem Schaltsignal initiiert wird, welches von einer Antriebssteuereinheit bzw. dem Steuergerät 108 des Fahrzeugs 100, welche/welches zur Ansteuerung eines elektrischen Achsantriebs ausgebildet ist, und/oder von einer elektronischen Steuereinheit des Fahrzeugs 100 erzeugt. Die Antriebssteuereinheit ist vorzugsweise dazu ausgebildet, einen halbleiterbasierten Umrichter, insbesondere den DC/AC-Wechselrichter 106 zur Umwandlung einer von der Antriebsbatterie 104 bereitgestellten DC-Spannung in eine AC-Spannung zur Bestromung des elektrischen Achsantriebs, einen vorzugsweise im On-Board-Lader 116 integrierten AC/DC-Gleichrichter zur Umwandlung einer AC-Eingangsspannung in eine DC-Ausgangsspannung, vorzugsweise zur Aufladung der Batterie, anzusteuern. Auf diese Weise kann der Schaltvorgang mittels bereits vorhandener Steuereinheit(en) initiiert werden, sodass keine zusätzliche Steuereinheit benötigt wird. Dies ermöglicht nicht nur eine Bauraumeinsparung, sondern auch einen zuverlässigen Schaltvorgang des Ladeschützes 32 und eine sichere elektrische Anregung der Antriebsbatterie 104.

Der elektrisch angeregte Zustand der Antriebsbatterie 104 kann alternativ oder zusätzlich mit Hilfe eines Ladezykluses und/oder eines Entladezykluses der Antriebsbatterie 104 hergestellt werden. Insbesondere umfasst der Strompuls zur elektrischen Anregung der Antriebsbatterie 104 einen Ladestrompuls des Ladezykluses und/oder einen Entladestrompuls des Entladezykluses. Der Ladezyklus bzw. Entladezyklus wird vorzugsweise durch die AC-Ladeeinrichtung 14, an die die Antriebsbatterie 104 angeschlossen ist, bereitgestellt. Vorzugsweise stellt die AC-Ladeeinrichtung 14 auf das Triggersignal 18 des Steuersystems 10 hin den Ladezyklus und/oder den Entladezyklus bereit. Das Triggersignal 18 kann auf der Benutzeroberfläche (User Interface, UI), welche auf dem Anzeigeelement (etwa Touch-Screen) eines Mobilgerätes und/oder eines Fahrzeugs 100 (bzw. dessen Infotainment-Systems) bereitgestellt wird, erzeugt werden, indem ein hierfür vorgesehenes virtuelles Kontrollelement wie eine virtuelle Triggertaste oder ein virtueller Triggerknopf auf dem Anzeigeelement bzw. Touch-Screen berührend betätigt wird. Hierdurch lässt sich die Antriebsbatterie 104 auf vereinfachte und zugleich sichere Weise elektrisch anregen, sodass die Batterieanalyse und -diagnose erleichtert ist.

Im einem weiteren Verfahrensschritt 206 werden die OBD-Messungen am Fahrzeug 100 durchgeführt, während sich die Antriebsbatterie 104 im elektrisch angeregten Zustand befindet. Die OBD-Messungen werden vorzugsweise basierend auf dem Startsignal 16 des Steuersystems 10 durch das OBD-System 12 (siehe Fig. 2) durchgeführt. Weiter vorzugsweise wird der elektrisch angeregte Zustand der Antriebsbatterie 104 überwacht und die OBD-Messungen abgebrochen, sobald der elektrisch angeregte Zustand über eine Schwellenzeitdauer nicht detektierbar oder instabil ist. In einem weiteren Verfahrensschritt 208 werden die OBD-Messdaten des Fahrzeugs 100 über die erste Kommunikationsschnittstelle 20 erhalten. Die OBD-Messdaten betreffen beispielsweise einen Ladezustand (State of Charge, SOC), eine Temperatur, Coulomb-Counting (CC-Daten), einen oder mehrere frühere Lade- und/oder Entladeprozesse, einen Strom und/oder eine Spannung der Antriebsbatterie 104.

In einem weiteren Verfahrensschritt 210 werden die OBD-Messdaten durch das Auswertemodul 22 ausgewertet, um einen Parameterdatensatz zu zumindest einem Betriebsparameter der Antriebsbatterie 104 zu erzeugen. Der zumindest eine Betriebsparameter umfasst eine Kapazität, einen Innenwiderstand, einen Ladezustand (State of Charge, SOC), eine Temperatur, einen Stromparameter (z.B. Stromstärke, Stromrichtung, Strompulsform) und/oder eine Spannung der Antriebsbatterie 104. Derartige Größen lassen sich beispielsweise mittels Coulomb-Counting aus den OBD-Messdaten gewinnen.

Alternativ oder zusätzlich lassen sich Kapazitäten, Ladezustände, Innenwiderstände, Temperaturen und/oder Spannungen der einzelnen Batteriemodule und/oder Batteriezellen aus den OBD-Messdaten extrahieren. Insbesondere können die OBD-Messdaten nach ihrer Sensorzugehörigkeit unterteilt werden, um jedem Sensor einen eigenen Parameterdatensatz zuzuordnen. Jeder Parameterdatensatz enthält Werte zu einem bestimmten Parameter. Diejenigen Parameterdatensätze, die den Einsatzzustand bzw. Betriebsparameter der Antriebsbatterie 104 betreffen oder deren Relevanz zum Einsatzzustand der Antriebsbatterie 104 eine vordefinierte Relevanzschwelle überschreitet, werden aus den insgesamt gewonnenen Parameterdatensätzen selektiert, woraus mehrere jeweils einem Batterie-Betriebsparameter zugeordnete Parameterdatensätze folgen. Alternativ können die OBD-Messdaten zunächst nach ihrer Relevanz zum Einsatzzustand der Batterie vorselektiert werden (z.B. nur diejenigen OBD-Messdaten, deren Relevanz zum Einsatzzustand der Antriebsbatterie 104 eine vordefinierte Relevanzschwelle überschreitet, werden vorselektiert). Die vorselektierten OBD-Messdaten werden anschließend nach ihrer Sensorzugehörigkeit unterteilt, woraus mehrere jeweils einem Batterie-Betriebsparameter zugeordnete Parameterdatensätze folgen. Weiter alternativ können zum Einsatzzustand der Antriebsbatterie 104 relevante Parameterdatensätze (Endparameterdatensätze) durch Weiterverarbeitung der wie vorstehend beschrieben gewonnenen Parameterdatensätze (Rohparameterdatensätze) erhalten werden, etwa um Messfehler und Messungenauigkeiten zu beseitigen, und/oder aus den Rohparameterdatensätzen, die den/die Betriebsparameter der Antriebsbatterie 104 nur indirekt betreffen, durch geeignete Rechenschritte den/die Betriebsparameter der Antriebsbatterie 104 direkt betreffende Endparameterdatensätze zu generieren.

Es ist denkbar, bei der Erzeugung des zumindest einen Parameterdatensatzes und/oder bei der Ermittlung der Zustandskennzahl eine Quereinflussinformation zu berücksichtigen. Die Quereinflussinformation umfasst zumindest eine der folgenden Informationen: eine Temperatur und/oder eine Temperaturverteilung der Antriebsbatterie 104 und/oder des Fahrzeugs 100, eine Fahrzeugmodellinformation des Fahrzeugs 100, eine Laufleistung/ein Kilometerstand des Fahrzeugs 100, ein geografischer Standort des Fahrzeugs 100, vorbestimmte Alterungswerte wie Alterungsrate der Antriebsbatterie 104, OBD-Messdaten vergleichbarer Batterietypen, Temperaturänderungen/-schwankungen während der OBD-Messung(en), und/oder ein Batteriemanagementsystem(BMS)-Parameter. In Fig. 5 ist rein schematisch gezeigt, dass die Quereinflussinformation 216 (hier durch gestrichelten Kreis angedeutet) im dortigen Datenverarbeitungsfluss berücksichtigt wird. Die Quereinflussinformation 216 kann nach dem Verfahrensschritt 208 (d. h. nach dem Empfang der OBD-Messdaten) berücksichtigt werden. Die Berücksichtigung der Quereinflussinformation 216 kann erfolgen, indem die OBD-Messdaten und die Quereinflussinformation 216 in Kombination dem zumindest einem Parameterdatensatz zugrunde gelegt werden. Alternativ oder zusätzlich kann der erzeugte Parameterdatensatz bzw. können die erzeugten Parameterdatensätze basierend auf der Quereinflussinformation korrigiert werden. Die Berücksichtigung der Quereinflussinformation bei der Erzeugung des Parameterdatensatzes und/oder bei der Ermittlung der Zustandskennzahl kann unter Verwendung eines neuronalen Netzwerkmodells, insbesondere eines Machine-Learning(ML)-Modells wie Large-Language-Modell (LLM) erfolgen, welches vortrainiert wurde. Durch die Berücksichtigung der Quereinflussinformation(en) kann der zumindest eine Parameterdatensatz zum Betriebsparameter der Antriebsbatterie 104 und/oder die Zustandskennzahl der Antriebsbatterie 104 mit höherer Präzision bereitgestellt werden. Die Batterieanalyse und -diagnose wird somit zuverlässiger.

In einem weiteren Verfahrensschritt 212 wird eine Zustandskennzahl der Antriebsbatterie 104, die den Einsatzzustand der Antriebsbatterie 104 charakterisiert, durch das Ermittlungsmodul 24 aus dem Parameterdatensatz ermittelt. Die Zustandskennzahl kann eine Restreichweite, insbesondere eine theoretische Restreichweite (TRR), der Antriebsbatterie 104 sein, die aus dem Parameterdatensatz/den Parameterdatensätzen zum Innenwiderstand bzw. zu den Innenwiderständen der Antriebsbatterie bzw. Batteriemodulen/-zellen, ermittelt wird. Auch ist es denkbar, ein Kapazitätsungleichgewicht zwischen den verschiedenen Batteriemodulen und/oder den verschiedenen Batteriezellen basierend auf den extrahierten Kapazitätswerten der einzelnen Batteriemodule bzw. Batteriezellen zu erhalten. Weitere Zustandskennzahlen umfassen einen Überladungsgrad und/oder einen Thermal Runaway-Grad und/oder einen weiteren Gesundheitszustandskennzahl (State of Health, SOH) der Antriebsbatterie 104.

Die Auswertung der OBD-Messdaten und/oder die Ermittlung der Zustandskennzahl erfolgt vorzugsweise unter Verwendung eines algorithmischen Modells, welches beispielsweise ein neuronales Netzwerkmodell (NN-Modell), insbesondere ein Machine-Learning-Modell (ML-Modell) umfasst. Das Modell umfasst ein Eingangsmodul zur Eingabe der OBD-Messdaten, insbesondere betreffend den SOC, die Temperatur, das Coulomb-Counting (CC-Daten), den früheren Lade- und/oder Entladeprozess, den Strom und/oder die Spannung der Antriebsbatterie 104. Das Modell umfasst ein Datenbereinigungsmodul, welches dazu ausgebildet ist, die OBD-Messdaten um ungültige Daten (bzw. Datenpunkte) zwecks Sicherstellung der Datenqualität zu bereinigen. Dazu ist das Datenbereinigungsmodul insbesondere dazu ausgebildet, SOC-Unregelmäßigkeiten wie Diskontinuitäten und/oder übersprungene SOC-Messschritte ("SOC steps") aus den OBD-Messdaten zu detektieren und zu entfernen. Alternativ oder zusätzlich ist das Datenbereinigungsmodul dazu ausgebildet, Datenpunkte, bei denen das Messzeitintervall (d.h. das Zeitintervall zwischen zwei aufeinanderfolgenden Messungen) zu vernachlässigen. Das Modell umfasst zusätzlich ein Vorprozessierungsmodul, um die vom Datenbereinigungsmodul bereitgestellten, bereits um ungültige Daten bzw. Datenpunkte bereinigten OBD-Messdaten vorzuprozessieren. Die Vorprozessierung dient beispielsweise dazu, (übrig gebliebene) fehlerbehaftete Datenpunkte zu beseitigen und/oder die OBD-Messdaten auf die Eingabe in ein Machine-Learning-Modul (ML-Modul) vorzubereiten (d.h. das ML-Modul ist ein weiteres Modul des gesamten ML-Modells). Alternativ oder zusätzlich ist das Vorprozessierungsmodul dazu ausgebildet, Pulsmessungen ("pulse measurements") durchzuführen, um sogenannte "virtuel edges" zu erzeugen, die zur Extraktion von Schlüsselmerkmalen verwendet werden, die auf den Gesundheitszustand der Antriebsbatterie 104 hinweisen.

Des Weiteren umfasst das Modell, welches vorzugsweise als ML-Modell vorliegt, ein Machine-Learning Modul (ML-Modul), welches vortrainiert und optional zusätzlich validiert ist. Das ML-Modul umfasst ein erstes Teilmodul zur Auswertung der OBD-Messdaten, insbesondere der vom Vorprozessierungsmodul bereitgestellten OBD-Messdaten. Das erste Teilmodul liefert hieraus zumindest einen Parameterdatensatz, insbesondere betreffend die Kapazität und/oder den Innenwiderstand der Antriebsbatterie 104. Das ML-Modul umfasst ein zweites Teilmodul zur Ermittlung der Zustandskennzahl, insbesondere des SOH und/oder der Restlebensdauer der Antriebsbatterie 104 aus dem Parameterdatensatz. Das Modell umfasst schließlich ein Ausgangsmodul zur Ausgabe der Zustandskennzahl, optional auch der anderen Datenverarbeitungsergebnisse (etwa der bereinigten und/oder vorprozessierten OBD-Messdaten, des Parameterdatensatzes).

Das ML-Modell und/oder das ML-Modul ist vorzugsweise als ein "gemischtes" bzw. kombiniertes ML-Modell ausgebildet, welches mehrere Sub-ML-Modelle umfasst. Diese Maßnahme erhöht die Genauigkeit der Batteriediagnose und/oder -prognose. Beispielsweise kann eines der Sub-ML-Modelle ein erstes Schätzer-Modell umfassen, welches einen zukünftigen Zeitpunkt abschätzt, bei dem die Batteriekapazität auf 80% ihres anfänglichen Wertes bzw. ihres Gesamtwertes fallen und somit den sogenannten C80-Zustand erreichen wird. Diese Schätzung dient somit als ein Indikator für die Restlebensdauer der Antriebsbatterie 104. Alternativ oder zusätzlich kann eines der Sub-ML-Modelle ein zweites Schätzer-Modell umfassen, welches die Alterungsrate der Antriebsbatterie 104 für Fahrzeuge abschätzt, bei denen der C80-Zustand noch nicht erreicht ist. Eine Zusammenführung der beiden obigen Sub-ML-Modelle ist dazu in der Lage, eine besonders zuverlässige SOH-Vorhersage unabhängig von aktuellem Fahrzeugzustand und verfügbaren Daten zu treffen.

Das ML-Modell bzw. das ML-Modul ist alternativ oder zusätzlich zum Transferlernen ("transfer learning") ausgebildet. Mittels des Transferlernens ist das ML-Modell dazu in der Lage, basierend auf eingegebenen OBD-Messdaten eines ersten Fahrzeug- und/oder Batterietyps einen oder mehrere Parameterdatensätze (etwa betreffend Kapazität und/oder Innenwiderstand) eines zweiten Fahrzeug- und/oder Batterietyps zu generieren. Dies erfolgt vorzugsweise dadurch, dass der Fahrzeug- und/oder Batterietyp als einer der Parameter ins zum Transferlernen trainierte ML-Modell eingegeben wird (bzw. dass die ersten und zweiten Fahrzeug- und/oder Batterietypen ins zum Transferlernen trainierte ML-Modell eingegeben werden). Das ML-Modell ist insbesondere durch das Trainieren auf Transferlernen dazu ausgebildet, eine Anpassung der Parameterdatensätze des ersten Fahrzeug- und/oder Batterietyps basierend auf einen Unterschied zwischen beiden Fahrzeug- bzw. Batterietypen durchzuführen. Dazu kann eine Look-Up-Table (LUT) oder eine andere Datenbank herangezogen werden, in der Anpassungsfaktoren zwischen dem ersten Fahrzeug- bzw. Batterietyp und dem zweiten Fahrzeug- bzw. Batterietyp vordefiniert sind. Auf diese Weise ist möglich, eine Analyse und/oder Diagnose der aktuellen Antriebsbatterie 104 mit hinreichender Genauigkeit durchzuführen, selbst wenn lediglich auf einen von der aktuellen Antriebsbatterie 104 verschiedenen Batterietypen bezogene und somit limitierte OBD-Messdaten verfügbar sind.

Das ML-Modell bzw. das ML-Modul ist alternativ oder zusätzlich dazu ausgebildet, eine Wahrscheinlichkeitslogik ("probabilistic logic" oder "probabilistic reasoning") zu involvieren. Die Wahrscheinlichkeitslogik wird insbesondere dazu verwendet, Konfidenzintervalle hinsichtlich der erzeugten Parameterdatensätze (etwa betreffend Kapazität und/oder Innenwiderstand), insbesondere durch Berücksichtigung von Unsicherheiten bzw. Toleranzen in den OBD-Messdaten und/oder im ML-Modell/ML-Modul zu ermitteln. Hierzu werden bevorzugt Bayesianische neuronale Netzwerke eingesetzt, die basierend auf der Qualitäts- und/oder Vollständigkeitsstufe der OBD-Messdaten Einsichten in die Unsicherheit der Vorhersage über die Restlebensdauer der Antriebsbatterie 104 bieten und für eine solche Vorhersage somit besonders geeignet sind.

Das algorithmische Modell, insbesondere das NN- bzw. ML-Modell, kann außerdem einen Feedback-Mechanismus umfassen, um die Erzeugung der Parameterdatensätze, die Ermittlung der Zustandskennzahl und/oder eine Alterungsprognose kontinuierlich hinsichtlich Genauigkeit zu optimieren. Der Feedback-Mechanismus kann alternativ oder zusätzlich dazu ausgestaltet sein, das ML-Modell/das ML-Modul anhand von realen Daten ("Real World Data") bzw. basierend auf Vergleichsergebnisse mit realen Daten anzupassen, wobei das ML-Modell/das ML-Modul optional mit Parameterdatensätzen (etwa betreffend Kapazität und/oder Innenwiderstand der Antriebsbatterie 104), die mit dem angepassten ML-Modell/ML-Modul gewonnen sind, erneut zu trainieren.

Schließlich wird in einem weiteren Verfahrensschritt 214 die Zustandskennzahl über die zweite Kommunikationsschnittstelle 26 ausgegeben. Beispielsweise wird die Zustandskennzahl an das Steuergerät 108 des Fahrzeugs 100 ausgegeben, um einen Kapazitätsausgleich zwischen den Batteriemodulen/-zellen (Battery Balancing) zu ermöglichen. Alternativ oder zusätzlich kann die ermittelte Zustandskennzahl an ein Anzeigegerät des Mobilgerätes ausgegeben werden, um das Ergebnis der Batterieanalyse und -diagnose zu visualisieren. Je nach Größe der ermittelten Zustandskennzahl kann die Visualisierung unterschiedlich erfolgen. Beispielsweise kann ein hervorhebender visueller Effekt im Fall eines Überschreitens einer vordefinierten Schwelle durch die Zustandskennzahl bereitgestellt werden. Diese Visualisierung kann zusätzlich in Kombination mit einem Audiosignal automatisiert werden. Auf diese Weise kann der Nutzer des Mobilgerätes den Einsatzzustand der Antriebsbatterie 104 in Echtzeit verfolgen und bei Anomalien oder in kritischen Situationen rechtzeitig Gegenmaßnahmen ergreifen.

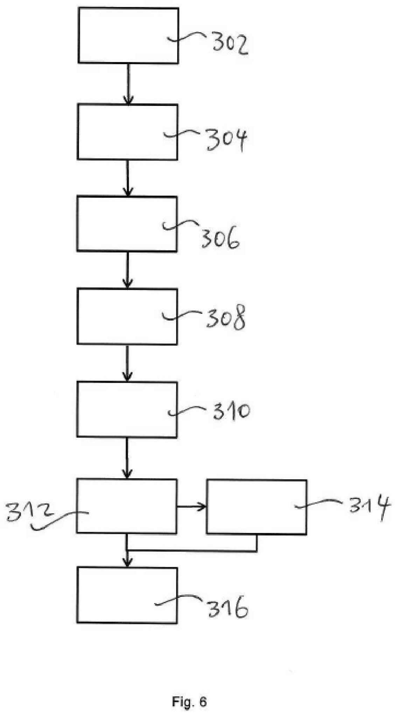

Fig. 6 zeigt das Verfahren zur Ermittlung des Einsatzzustands der Antriebsbatterie 104 gemäß einer weiteren beispielhaften Ausführungsform. Wie dort schematisch und rein beispielhaft gezeigt, kann das Verfahren ferner Schätzen eines Alters, einer Alterungsrate und/oder einer Restlebensdauer der Antriebsbatterie 104 basierend auf der ermittelten Zustandskennzahl umfassen (entsprechend dem Verfahrensschritt 314 in Fig. 6). Die Verfahrensschritte 302, 304, 306, 308, 310, 312, 316 aus Fig. 6 entsprechen jeweils den in Fig. 5 gezeigten Verfahrensschritten 202, 204, 206, 208, 310, 212, 214 in einer Eins-zu-Eins-Entsprechung. Obwohl in Fig. 6 nicht explizit gezeigt, ist auch hier eine Berücksichtigung der Quereinflussinformation 216 wie bei der in Fig. 5 gezeigten Ausführungsform analog denkbar. Zwecks der Schätzung wird die ermittelte Zustandskennzahl an ein Schätzungsmodul (hier nicht gezeigt) des Steuersystems 10 ausgegeben, welches hierauf basierend das Alter, die Alterungsrate und/oder die Restlebensdauer der Antriebsbatterie 104 berechnet. Hierdurch wird das Resultat der Batterieanalyse- und Diagnose um eine Alterungsprognose erweitert bzw. vervollständigt. Des Weiteren zeigt Fig. 6 mehrere mögliche Datenpfade: eine erste Option, bei der keine Alterungsprognose durchgeführt und nur die ermittelte Zustandskennzahl ausgegeben wird (der zugehörige Datenpfad verläuft "vertikal" und nicht über den Verfahrensschritt 314); und eine zweite Option, bei der die Alterungsprognose basierend auf der ermittelten Zustandskennzahl durchgeführt wird, wobei das Resultat der Alterungsprognose entweder nach der Ausgabe der Zustandskennzahl oder gleichzeitig dazu ausgegeben wird (der zugehörige Datenpfad verläuft zweischienig sowohl "vertikal" als auch über den Verfahrensschritt 314).

Erfindungsgemäß wird ein intelligentes Batterieanalyse und -diagnoseverfahren bewerkstelligt, bei dem ausschließlich OBD-Messdaten herangezogen werden. Ein Zugriff auf zusätzliche Sensorik ist somit nicht erforderlich, um den Einsatzzustand der Antriebsbatterie 104 zu bestimmen. Insbesondere entfällt hierdurch die Notwendigkeit, Daten von Ladestationen bzw. Ladesäulen herzuziehen und zu analysieren, sodass die Anzahl der involvierten Datenschnittstellen reduziert wird. Dies führt zur erhöhten Sicherheit und Fehlerbeständigkeit der Batterieanalyse- und Diagnose.

Zusätzlich wird durch das Schalten des Ladeschützes der Ladeeinrichtung, insbesondere der AC- und/oder DC-Ladeeinrichtung ermöglicht, dass sich der Stromfluss durch den im Fahrzeug 100 eingebauten On-Board-Laders 116 auf einen vordefinierten Schwellenwert reduzieren lässt, vorzugsweise auf Null, sodass der On-Board-Lader 116 vollständig stromlos geschaltet wird. Hierdurch verlässt das Fahrzeug 100 den Ladebetrieb, wobei nicht notwendige Nebenverbraucher abgeschaltet werden können. Somit reguliert der On-Board-Lader 116 die Leistung autonom und ganz ohne oder nur mit insignifikanter Interaktion mit externen Systemen. Hieraus resultiert ein vergleichsweise stabiler Strompuls mit wiederholgenauen Plateaus zur elektrischen Anregung der Antriebsbatterie 104. Auf diese Weise wird die Wiederholgenauigkeit der Batterieanalyse- und Diagnose verbessert und die Bestimmung des Innenwiderstandes der Antriebsbatterie 104 vereinfacht.

### Bezugszeichenliste

- 10: Steuersystem
- 12: OBD-System
- 14: Ladeeinrichtung
- 16: Startsignal
- 18: Triggersignal
- 20: erste Kommunikationsschnittstelle
- 22: Auswertemodul
- 24: Ermittlungsmodul
- 26: zweite Kommunikationsschnittstelle
- 32: Ladeschütz
- 100: zumindest teilweise elektrifiziertes Fahrzeug
- 102: Elektromotor
- 104: Antriebsbatterie
- 106: DC/AC-Wechselrichter
- 108: Steuergerät
- 110: Hinterachse
- 112: Getriebe
- 114: Hinterräder
- 116: On-Board-Lader
- 202-214: Verfahrensschritte
- 216: Quereinflussinformation
- 302-316: Verfahrensschritte

## Patentansprüche

1. Verfahren zur Ermittlung eines Einsatzzustands einer Batterie (104) eines zumindest teilweise elektrifizierten Fahrzeugs (100), umfassend:
- Erhalten von On-Board-Diagnose-Messdaten, OBD-Messdaten, des Fahrzeugs (100) über eine erste Kommunikationsschnittstelle (20), wobei die OBD-Messdaten während eines elektrisch angeregten Zustandes der Batterie (104) erzeugt sind;
- Auswerten, vorzugsweise ausschließlich, der OBD-Messdaten, um einen Parameterdatensatz zu zumindest einem Betriebsparameter der Batterie (104) zu erzeugen;
- Ermitteln einer Zustandskennzahl der Batterie (104), vorzugsweise ausschließlich, aus dem Parameterdatensatz, wobei die Zustandskennzahl einen Einsatzzustand der Batterie (104) charakterisiert;
wobei der elektrisch angeregte Zustand der Batterie (104) basierend auf einem Schaltvorgang eines Ladeschützes (32) einer Ladeeinrichtung (14), an die die Batterie (104) angeschlossen ist, bereitgestellt wird; und/oder
wobei der elektrisch angeregte Zustand der Batterie (104) mittels einer AC-Ladeeinrichtung (14), an die die Batterie (104) angeschlossen ist, bereitgestellt wird.

2. Verfahren nach Anspruch 1, wobei der Schaltvorgang des Ladeschützes (32) Einstellen eines Widerstandswertes des Ladeschützes (32) umfasst, wobei das Einstellen des Widerstandswertes des Ladeschützes (32) vorzugsweise kontinuierlich oder diskret ist.

3. Verfahren nach einem der vorhergehenden Ansprüche, wobei der Schaltvorgang des Ladeschützes (32) Einschalten und/oder Ausschalten des Ladeschützes (32) umfasst.

4. Verfahren nach einem der vorhergehenden Ansprüche, wobei die Ladeeinrichtung (14) bzw. die AC-Ladeeinrichtung (14) dazu ausgebildet ist, eine Stromversorgung für einen On-Board-Lader (116) bereitzustellen, der zur elektrischen Anregung der Batterie (104) mit dieser elektrisch verbunden ist, wobei der On-Board-Lader (116) vorzugsweise dazu ausgebildet ist, eine von der AC-Ladeeinrichtung (14) bereitgestellte AC-Spannung in eine DC-Spannung zur elektrischen Anregung der Batterie (104) umzuwandeln.

5. Verfahren nach Anspruch 4, wobei der Schaltvorgang des Ladeschützes (32) dazu ausgebildet ist, einen Stromfluss durch den On-Board-Lader (116) auf einen vordefinierten Schwellenwert, vorzugsweise iterativ, einzustellen.

6. Verfahren nach Anspruch 5, wobei der Schaltvorgang des Ladeschützes (32) dazu ausgebildet ist, den On-Board-Lader (116) vollständig stromlos zu schalten.

7. Verfahren nach einem der vorhergehenden Ansprüche, wobei der Schaltvorgang des Ladeschützes (32) der Ladeeinrichtung (14) dazu ausgebildet ist, einen Strompuls, vorzugsweise iterativ, einzustellen, wobei der elektrisch angeregte Zustand der Batterie (104) durch Beaufschlagung der Batterie (104) mit dem eingestellten Strompuls hergestellt wird.

8. Verfahren nach Anspruch 7, wobei der Strompuls einen Ladestrompuls eines Ladezykluses und/oder einen Entladestrompuls eines Entladezykluses umfasst.

9. Verfahren nach Anspruch 7 oder 8, wobei der Schaltvorgang des Ladeschützes (32) derart gewählt wird, dass der erzeugte Strompuls gleichmäßig ist.

10. Verfahren nach Anspruch 9, wobei der Schaltvorgang des Ladeschützes (32) ein iteratives Einstellen eines Schaltparameters umfasst, bis ein Gleichmäßigkeitsgrad des erzeugten Strompulses einen vordefinierten Minimalwert überschreitet.

11. Verfahren nach einem der vorhergehenden Ansprüche, wobei der Schaltvorgang des Ladeschützes (32) basierend auf einem Schaltsignal initiiert wird, welches von einer Antriebssteuereinheit (106) des Fahrzeugs (100), welche zur Ansteuerung eines elektrischen Achsantriebs ausgebildet ist, und/oder von einer elektronischen Steuereinheit des Fahrzeugs (100) erzeugt wird.

12. Steuersystem (10) zur Ermittlung eines Einsatzzustands einer Batterie (104) eines zumindest teilweise elektrifizierten Fahrzeugs (100), wobei das Steuersystem (10) dazu ausgebildet ist, das Verfahren nach einem der vorhergehenden Ansprüche auszuführen.

13. Steuersystem (10) nach Anspruch 12, wobei das Steuersystem (10) zumindest teilweise, vorzugsweise vollständig, auf einem Mobilgerät, beispielsweise einem Smartphone und/oder einem Tablett, welches weiter vorzugsweise einen Touch-Screen aufweist, bereitgestellt ist.

14. Zumindest teilweise elektrifiziertes Fahrzeug (100), umfassend ein Steuersystem (10) nach Anspruch 12 oder 13.

15. Computerlesbares Speichermedium, umfassend Befehle, die bei der Ausführung durch einen Computer diesen veranlassen, die Schritte des Verfahrens nach einem der Ansprüche 1 bis 11 auszuführen.
